# EUROPÄISCHE PATENTSCHRIFT

(11) **EP 0 401 608 B1**
(45) Veröffentlichungstag und Bekanntmachung des Hinweises auf die Patenterteilung: **08.03.1995**
(21) Anmeldenummer: 90109865.7
(22) Anmeldetag: 23.05.1990
(51) Int. Cl.: G02B 3/00, G02B 7/02

(54) **Linsenraster**
Lens array
Arrangement de lentilles

(30) Priorität: 05.06.1989 DE 3918293
(43) Veröffentlichungstag der Anmeldung: 12.12.1990
(73) Patentinhaber: Firma Carl Zeiss, D-73446 Oberkochen (DE)
(72) Erfinder: Rossmann, Dieter, D-7080 Aalen (DE); Wangler, Johannes, D-7923 Königsbronn (DE)

(56) Entgegenhaltungen:
- EP-A- 0 135 234
- EP-A- 0 267 599
- DE-A- 3 146 026
- US-A- 4 175 844

## Beschreibung

Die Erfindung betrifft ein Linsenraster aus diskreten Linsenelementen nach dem Oberbegriff des Anspruchs 1.

Linsenraster der oben genannten Art (bspw. aus EP-A-0 135 234 bekannt) werden insbesondere überall dort verwendet, wo eine Fläche möglichst homogen ausgeleuchtet werden soll.

Aus der US-PS 35 80 675 ist ein Linsenraster bekannt, bei dem die Linsenelemente in einer Linie angeordnet sind. Zwischen den diskreten Linsenelementen besteht kein Abstand. Die Linsenelemente werden dabei seitlich gehalten. Die beiden optisch wirksamen Flächen sind gleich groß und die Linsenelemente sind an keiner Stelle verjüngt. Die Art der Befestigung erlaubt keine flächige Anordnung der Linsenelemente, da seitlich der Linsenelemente ein breiter Raum zur Befestigung der Linsenelemente notwendig ist.

Aus der DE-PS 29 51 452 ist ein Linsenraster bekannt, welches als Linsenobjektiv verwendet wird. In diesem Linsenraster können von einem Träger maximal zwei Reihen von Linsenelementen gehalten werden. Eine mechanische Abstützung durch den Träger erfolgt nicht, sondern die einzelnen Linsen können in maximal zwei Reihen ohne Zwischenraum aneinandergelegt werden. Außer dem bei hoher Ausnutzung der eingestrahlten Energie recht labilen Aufbau erlaubt die Art der Halterung in diesem Fall auch keine flächige Anordnung der Linsenelemente, da der Träger an beiden Seiten weit über die benutzten optischen Flächen hinausragt.

Ein weiteres Linsenraster ist aus der DE-PS 968 430 bekannt, bei welchem die Linsenelemente auf einer Planplatte aufgebracht sind. Derartige Linsenraster werden heute im Spritzguß oder durch Aufkitten von diskreten Linsenelementen auf eine plane Glasplatte hergestellt. Damit ist es mit diesem Linsenraster möglich, eine flächige Anordnung von Linsenelementen zu erreichen, wobei die Linsenelemente sehr eng aneinander angeordnet sein können. Nachteilig ist die Ungenauigkeit der optischen Abbildung bei im Spritzgußverfahren (bei welchem Plastik, aber kein Glas als Linsenmaterial verwendet werden kann) hergestellten Linsenrastern, was eine Verwendung derart hergestellter Linsenraster in optischen Präzisionsmaschinen unmöglich macht. Keine Einschränkung der optischen Qualität bei der Abbildung muß man hinnehmen, wenn die diskreten Linsenelemente auf die Glasplatte aufgekittet werden. Nachteilig ist dann aber, daß eine Strahlungsabsorption an der Glasplatte erfolgt, und daß weitere optische Übergänge an der Kittschicht auftreten, welche sich im optischen Strahlengang befindet. Gravierend ist der fertigungstechnisch bedingte enorme Aufwand beim Aufkitten der vielen diskreten Linsenelemente. Durch den Kitt sind Linsenraster mit auf einer auf eine transparente Grundplatte aufgekittenen Linsenelementen auch nicht in allen Einsatzbereichen verwendungsfähig, da die Haltbarkeit der Kitte gegen chemische Einflüsse und gewisse Strahlungsbereiche teilweise zeitlich sehr begrenzt ist.

Aus der DE-PS 33 25 581 ist ein vakuumdichtes Strahlungsfenster bekannt, bei welchem mehrere nebeneinanderliegende Einzellinsen in einer metallischen Halterung gehalten werden. Für den Einsatz in der Wand einer Vakuumkammer ist eine hohe mechanische Festigkeit erforderlich; außerdem muß dieser Linsenraster gekühlt werden. Durch die Gestaltung der Linsenelemente kann hier keine optimale Ausnutzung eines großflächig eingestrahlten Strahlenbündels erfolgen.

Aufgabe der Erfindung ist es, viele Linsenelemente in Ausnehmungen eines mechanisch stabilen Trägers so anzuordnen, daß die haltenden Teile des Trägers die nutzbare optische Eintrittsfläche der Linsenelemente nicht verringern und daß eine freie Gestaltung des über den Rand der optischen Flächen der Linsenelemente hinausragenden Teile des Trägers ermöglicht ist.

Die gestellte Aufgabe wird erfindungsgemäß entsprechend dem kennzeichnenden Teil des ersten Patentanspruchs gelöst.

Das erfindungsgemäße Linsenraster zeichnet sich dadurch aus, daß viele diskrete Linsenelemente, die einzeln gefertigt und nach vorgegebenen Qualitätskriterien ausgesucht wurden, zu einem linearen oder flächigen Linsenraster lückenlos aneinandergefügt sind, wobei eine hohe mechanische Stabilität des Linsenrasters gegeben ist. Obwohl die diskreten Linsenelemente von dem Träger seitlich eine Unterstützung erfahren, indem die Linsenelemente jeweils in einer Ausnehmung des Trägers mechanisch stabil aufgenommen werden, schränkt der Träger mit keinem seiner Teile die optisch wirksame Fläche der diskreten Linsenelemente ein, da er für seine Unterstützung die optisch nicht genutzten Bereiche der Linsenelemente verwendet. Dadurch ist eine maximale Ausnutzung der eingestrahlten Energie möglich, bei minimierbarer Dicke der diskreten Linsenelemente.

Ein weiterer wesentlicher Vorteil ist die vereinfachte Montage der Linsenelemente in die jeweiligen Ausnehmungen des Trägers, welche sehr viel schneller und präziser durchgeführt werden kann als beispielsweise das Aufkitten vieler Linsenelemente auf eine plane Grundplatte. Bei dem Linsenraster nach der Erfindung sind auch optisch nicht transparente Kitte für die Befestigung der Linsenelemente am Träger verwendbar. Es besteht auch die Möglichkeit ganz auf einen Kitt zu verzichten und die Linsenelemente rein mechanisch stabil festzulegen. Dies ist besonders bei Einsatz des Linsenrasters in den Bereichen wichtig, in welchen auf das Linsenraster chemische Stoffe oder Strahlung aus einem sehr kurzwelligen Bereich einwirken, gegen welche ein Kitt nur eine begrenzte Zeit resistent ist.

Durch die bei dem neuen Linsenraster mögliche allseitige Unterstützung der Linsenelemente durch den Träger können insbesondere Linsenelemente stabil mechanisch unterstützt werden, deren optisch genutzte Flächendiagonale größer ist als die jeweilige Linsendicke. Die Vorteilhaftigkeit des Linsenrasters tritt besonders bei der flächigen Anordnung der Linsenelemente zu einem Flächenraster hervor, da der Träger die einzelnen Linsenelemente an den Rändern der kleineren optischen Fläche unterstützt. Dadurch kann ein mechanisch stabiles Linsenraster ohne das bisher übliche Aufkitten der Linsenelemente auf eine gemäß den mechanischen Festigkeitserfordernissen entsprechende dicke, stoßempfindliche Glasplatte sehr viel gewichtsärmer aufgebaut werden. Trotz der mechanischen Festigkeit des Linsenrasters kann man bei entsprechender Gestaltung der optischen Oberflächen der Linsenelemente eine geschlossene optisch wirksame Oberfläche des Linsenrasters erhalten.

Damit die Linsenelemente in den Ausnehmungen des Trägers einen sicheren Halt finden, muß man sie in den optisch nicht genutzten Bereichen verjüngen. Diese Verjüngung kann konisch oder zylinderförmig in Form eines Absatzes erfolgen. Die Linsenelemente können wahlweise je nach Einsatznotwendigkeiten mechanisch von dem Träger gehalten oder an ihn angekittet werden. Soweit möglich wird man ein Ankitten der Linsenelemente an den Träger bevorzugen, um die Dicke der transparenten Materialen und damit deren Absorption zu minimieren. Bei gewissen Wellenbereichen, insbesondere im kurzwelligen Bereich, kann sich aber ein Übergang zu einer mechanischen Festlegung für notwendig erweisen, da die Strahlung dann den Kitt mit der Zeit zerstört. Dann kann man die Linsenelemente in den Träger einstecken und durch eine dünne Planplatte die Linsenelemente auf dem Träger fixieren. Dies hat den Vorteil, daß keine mechanischen Spannungen auf die Linsenelemente übertragen werden.

Um eine Überlagerung der aus den Linsenelementen austretenden diskreten Strahlenbündel in einer Ebene zur Ausleuchtung einer Fläche zu erreichen, kann hinter dem Linsenraster eine Sammellinse angebracht werden. Vorteilhaft ist es für diesen Zweck zwei Linsenraster hintereinander anzubringen und diese relativ zueinander auszurichten, wobei sich die kleineren optisch genutzten Flächen zwischen den Linsenrastern befinden. Dadurch erhält man eine Aufteilung eines Beleuchtungsstrahles in viele diskrete Teilstrahlen ohne Energieverlust.

Aufgrund der hohen Übertragung der Lichtenergie bei gleichzeitiger Aufteilung eines Lichtstrahles in mehrere diskrete, ihrer Form nach variable Strahlenbündel ist das Linsenraster besonders zum Einbau in Geräte geeignet, in denen eine definierte Fläche homogen mit der Energie eines Strahles mit einer bestimmten Wellenlänge ausgeleuchtet werden soll. Deshalb ist der Einbau eines derartigen Linsenrasters in einen Waferstepper von Vorteil, wo das Linsenraster einen Teil des Kondensors der Beleuchtungsoptik bildet.

Die Erfindung wird nachstehend anhand der in den beigefügten Zeichnungen dargestellten Ausführungsbeispiele näher erläutert, wobei weitere wesentliche Merkmale sowie dem besseren Verständnis dienende Erläuterungen und Ausgestaltungsmöglichkeiten des Erfindungsgedankens beschrieben sind.

Dabei zeigt
- Fig. 1: einen Schnittpunkt mehrerer Linsenelemente in dreidimensionaler Ansicht mit Stegen eines Trägers zur Festlegung der Linsenelemente;
- Fig. 1a: einen zum Steg aus Fig. 1 alternativen Steg mit tragenden Schultern;
- Fig. 2: ein diskretes Linsenelement in Aufsicht;
- Fig. 2a,b: eine Seitenansicht des Linsenelementes aus Fig. 2 mit konischen Seitenflächen;
- Fig. 2c,d: eine Seitenansicht des Linsenelementes aus Fig. 2 mit konischen, einen Absatz beinhaltenden Seitenflächen;
- Fig. 3: einen Bereichsausschnitt aus einem Linsenraster;
- Fig. 4: ein Linsenraster in Aufsicht;
- Fig. 5: eine seitliche Ansicht einer Doppellinsenraster-Anordnung.

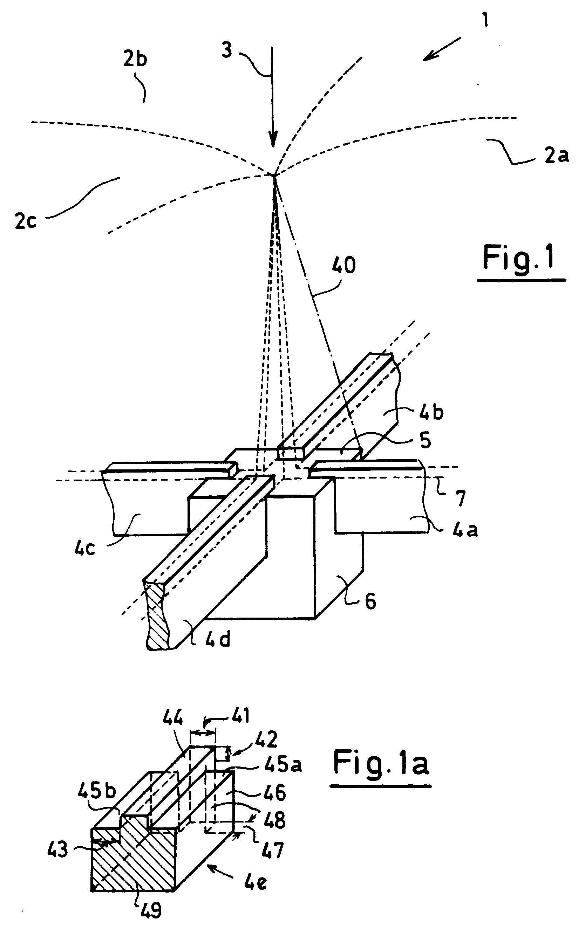

In Fig. 1 treffen vier schematisch dargestellte Linsenelemente (2a-d) mit rechteckförmigen optisch wirksamen Flächen an einer ihrer Ecken in einem Punkt des Linsenrasters (1) spitz aufeinander. Die Linsenelemente (2a-d) liegen mit den Rändern ihrer größeren optischen Flache eng aneinander und bilden aus Richtung der optischen Achse (3) gesehen eine geschlossene Strahleneintrittsfläche für das Linsenraster (1). Die Linsenelemente (2a-d) verjüngen sich konisch von der oberen zur unteren optisch wirksamen Flache. Dadurch entsteht zwischen den Linsenelementen (2a-d) ein sich nach unten verbreiternder Freiraum. In dem unteren Teil dieses Freiraumes ragen Stege (4a-d) des Trägers mit ihrem oberen Bereich (7) hinein und geben den Linsenelementen (2a-d) einen seitlichen Halt. Eine Auflageunterstützung erhalten die Linsenelemente (2a-d) an einem Haltekörper (6), auf welchem sie mit ihren Ecken (5) aufliegen. Die Stege (4a-d) sind in dem Haltekörper (6) eingesteckt und starr mit diesem verbunden. Zur Kennzeichnung der optisch genutzten Bereiche der Linsenelemente (2a-d) ist ein Strahl (40) eingezeichnet.

In Fig. 1a ist ein modifizierter Steg (4e) gezeigt, welcher anstelle der Stege (4a-d) aus Fig. 1 verwendet werden kann. Dieser Steg (4e) bietet nicht nur einen seitlichen Halt für die Linsenelemente (2a-d in Fig. 1) wie die Stege (4a-d) aus Fig. 1, sondern gibt den Linsenelementen (2a-d in Fig. 1) auch zwischen zwei Haltekörpern entlang deren seitlichen unteren Begrenzungskante eine Auflagefläche (45a-b).

Der Steg (4e) besteht aus einem Grundkörper (49), auf dessen oberer Deckfläche ein Aufsatz (44) angebracht ist. Dieser Aufsatz (44) unterteilt die Deckfläche in drei Bereiche. Die Linsenelemente (2a-d) finden auf den seitlichen Flächen (45a-b) des Steges (4e) eine Auflagefläche, wobei die mögliche Breite (43) der beiden Auflageflächen sich als Differenz zwischen den unten optisch wirksamen Flachen zweier aneinandergrenzender Linsenelemente abzüglich der Breite (41) des Aufsatzes (44) ergibt. Dadurch können die Linsenelemente (2a-d aus Fig. 1) sicher von dem Steg (4e) unterstützt werden, ohne ihre optische Funktion einzuschränken, da der Steg (4e) die optisch genutzten Flächen der eingesetzten Linsenelemente nicht einschränkt.

Der sich auf dem Grundkörper (49) befindliche Aufsatz (44) ist am Ende des Grundkörpers (49) mittig als Einschubaufsatz (48) ausgebildet. Nicht nur die Breite (41) des Aufsatzes (44) sondern auch seine Höhe (42) sind so bemessen, daß der Aufsatz (44) ungestört in den unteren Freiraum zwischen zwei aneinandergrenzenden Linsenelemente (2a-d) hineinragt. Mit dem Einschubaufsatz (48) greift der Steg (4e) in einen Haltekörper (6) mit der ganzen Länge (47) des Einschubaufsatzes (48) hinein und wird so von dem Haltekörper (6) sowohl abgestützt als auch seitlich gehalten. Die Befestigung des Steges (4e) am Haltekörper (6) kann durch Klebung oder eine mechanische Befestigung (Verschrauben, Verkeilen, usw.) erfolgen.

Sollte der seitliche Halt der Linsenelemente durch den Aufsatz (44) des Steges (4e) nicht ausreichend sein, so können die Linsenelemente einen weiteren seitlichen Halt dadurch erlangen, daß der Aufsatz (44) des Steges (4e) entsprechend der Verjüngung der Linsenelemente ausgeführt ist. Wenn es die konstruktive Gestaltung der Linsenelemente erlaubt, können diese auch einen Absatz im unteren Teil der konischen Seitenflächen haben, so daß die Linsenelemente nicht nur am Aufsatz (44) des Steges (4e), sondern auch an dessen seitlichen Begrenzungsflächen (46) anliegen.

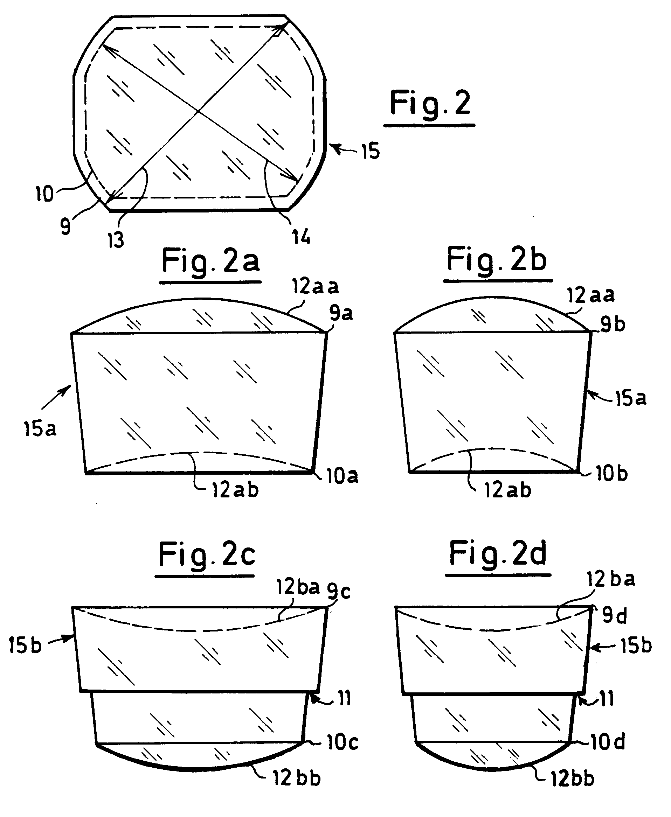

In Fig. 2 ist ein Linsenelement (15) in Aufsicht gezeigt, welches sich zum Ausleuchten einer rechteckigen Fläche mit gerundeten Kanten eignet. Das Linsenelement (15) besitzt eine große obere optisch wirksame Fläche (durchgezogene Begrenzungslinie 9), deren Flächendiagonale (13) größer ist als die Flächendiagonale (14) der kleineren unteren optisch wirksamen Fläche (gestrichelte, innere Begrenzungslinie 10). Die Begrenzungslinien (9,10) der beiden optisch wirksamen Flächen begrenzen den Raum, welcher sich an der kleineren optisch wirksamen Fläche maximal als Unterstützungsfläche für den Steg eines Trägers ergibt. Da das Linsenelement (15) eine konische Form hat und sich ausgehend von der größeren optisch wirksamen Fläche (9) hin zur kleineren optisch wirksamen Fläche (10) verjüngt entsteht an den Seiten des Linsenelementes (15) ein Freiraum. Die effektiv mögliche Größe dieses Freiraumes wird dabei durch die Einstrahlungsbedingungen sowie durch die Gestaltung der optisch wirksamen Flächen festgelegt.

In den Fig. 2a-b und Fig. 2c-d sind seitliche Ansichten mehrerer Ausführungsformen des Linsenelementes (15) aus Fig. 2 gezeigt, wobei die Gestaltung insbesondere der beiden optisch wirksamen Flächen lediglich beispielhaft ist.

Das Linsenelement (15a) in Fig. 2a-b hat ein konvexe größere optisch wirksame Fläche (12aa) und eine konkave kleinere optisch wirksame Fläche (12ab). Ausgehend von der Begrenzungslinie (9a-b) der größeren oberen optisch wirksamen Fläche (12aa) hin zur kleineren unteren optisch wirksamen Fläche (12ab) verjüngen sich die Seiten des Linsenelementes (15a) stetig, so daß das Linsenelement (15a) in Richtung der optischen Achse konisch abgewinkelte Seiten hat. Dadurch entsteht zwischen zwei aneinandergrenzenden Linsenelementen ein dreiecksförmiger Freiraum, in den ein Aufsatz eines Steges für eine seitliche Festlegung der Linsenelemente (15a) eingreifen kann. Durch die konstruktive Gestaltung dieses Linsenelementes (15a) kann sowohl der seitliche Halt als auch die Unterstützung von unten an den seitlichen Begrenzungsflächen des Linsenelementes (15a) erfolgen, wobei die Stege eines Trägers zur Aufnahme der Linsenelemente in ihrer Form exakt den seitlichen Begrenzungsflächen der Linsenelemente (15a) angepaßt sein müssen, da nur diese für die Festlegung eines Linsenelementes an die Stege eines Trägers zur Verfügung stehen und die Stege sich ganz in dem durch die konischen Seitenflächen der Linsenelemente (15a) gebildeten Freiraum befinden. Dies bedingt eine sehr genaue Fertigung der Stege des Trägers, welche wegen der abgeschrägten Seiten dieser Stege zu Problemen führen kann. Leichter sind Stege herzustellen, deren Kontaktflächen mit den jeweiligen Linsenelementen senkrecht zueinander verlaufen. Diese fertigungstechnischen Vorgaben sind in den seitlichen Ansichten eines anderen Linsenelementes (15b) in den Fig. 2c-d berücksichtigt, wobei die Aufsicht dem Linsenelement (15) aus Fig. 1 entspricht.

Das Linsenelement (15b) hat eine konkave größere obere optisch wirksame Fläche (12ba) und eine konvexe kleinere untere optisch wirksame Fläche (12bb). Von der oberen Begrenzungslinie (9c-d) der größeren optisch wirksamen Fläche ausgehend verjüngt sich das Linsenelement (15b) seitlich in Richtung auf die untere Begrenzungslinie (10c-d) der kleineren optisch wirksamen Fläche nicht stetig. Im oberen Teil des Linsenelementes (15b) verjüngt sich das Linsenelement (15b) nur ganz wenig konisch. Im unteren Teil ist ein Absatz (11) vorhanden. Unterhalb verlaufen die beiden seitlichen Begrenzungen zueinander wieder leicht konisch, so daß das Linsenelement (15b) als ganzes im optisch nicht genutzten Bereich zylinderförmig verjüngt ist. Die leicht konische Form der seitlichen unteren und oberen Begrenzungen des Linsenelementes (15b) erleichtert das Einsetzen der Linsenelemente (15b) in die Ausnehmungen des Trägers; prinzipiell könnten die Seitenflächen auch parallel zueinander verlaufen.

Mit dem Absatz (11) liegt das Linsenelement (15b) auf den Stegen des Trägers eines Linsenrasters auf, wodurch sowohl eine sichere untere Unterstützung als auch ein problemfreier seitlicher Halt für das Linsenelement (15b) gewährleistet ist. Die maximale Größe des Absatzes ergibt sich aus dem Verhältnis der kleineren zur größeren optisch wirksamen Fläche, aus der gerätespezifischen Einstrahlgeometrie sowie aus dem Abschrägungsgrad der seitlichen Begrenzungsflächen. Bei den in das Linsenraster sinnvoller Weise einsetzbaren Linsenelementen (15b) besteht immer die Möglichkeit, den vorab beschriebenen Absatz (11) aus dem Material der Linsenelement (15b) herauszuarbeiten, da man eine relativ freie Gestaltungsmöglichkeit des Überganges von der größeren zur kleineren optisch wirksamen Fläche hat.

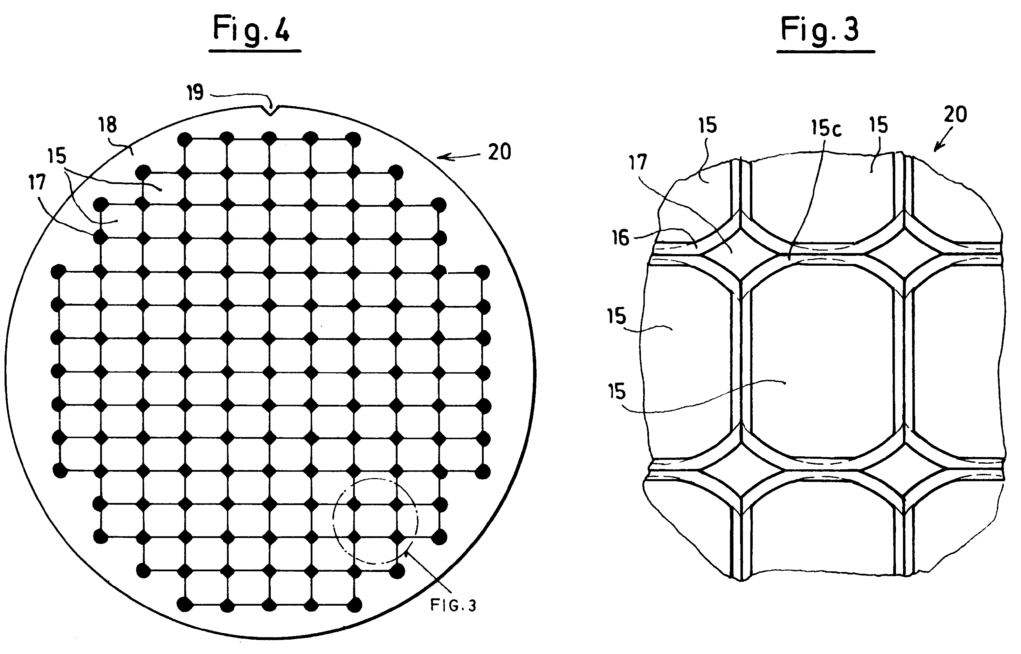

In Fig. 3 ist eine Detailansicht des Linsenrasters (20) aus Fig. 4 zu sehen, wobei die Linsenelemente (15) in die durch die Stege (16) begrenzten Ausnehmungen des Trägers eingesetzt sind. Mit ihrer größeren optisch wirksamen Fläche liegen die diskreten Linsenelemente (15) eng aneinander. Die Linsenelemente (15) haben zwei ungleich große, optisch wirksame Flächen und verjüngen sich ausgehend von der oben optisch wirksamen Fläche hin zur unteren optisch wirksamen Fläche an allen vier Seiten des rechteckigförmigen Linsenelementes (15).

In dem entstehenden Freiraum zwischen zwei Linsenelementen (15) geben Stege (16) den Linsenelementen (15) einen sicheren Halt. Die Stege (16) liegen nur an den sich verjüngenden Seiten der Linsenelemente (15) an und ragen nicht aus dem durch die Verjüngung der Linsenelemente (15) entstandenen Freiraum zwischen den Linsenelementen (15) hinaus. Die Form der optisch wirkenden Flächen der Linsenelemente (15) ist hier durch die Form der homogen auszuleuchtenden Fläche bedingt, welche rechteckförmig ist mit abgerundeten Kanten. Bedingt durch ihre Form ragen die oberen optisch wirkenden Flächen der Linsenelemente (15) über die Stege (16) des Trägers des Linsenrasters (20) hinaus.

Bedingt durch die geometrische Form der optisch wirkenden Flächen der Linsenelemente (15) entstehen an ihren Ecken zwischen den Linsenelementen Freiräume, in welchen die Haltekörper (17) an den Knotenpunkten der Stege (16) untergebracht sind.

In Fig. 4 ist das Linsenraster (20) in Aufsicht als ganzes zu sehen. Die Linsenelemente (15) sind regelmäßig so über das Linsenraster (20) verteilt, daß es zu einer maximalen Ausnutzung der Fläche kommt (maximale Packungsdichte). Lediglich durch die entsprechend der auszuleuchtenden optischen Fläche abgerundeten Ecken der Linsenelemente (15) treten an den sichtbaren Haltekörpern (17) Energieverluste auf. Die Anordnung der Linsenelemente (15) ist außen von einem stabilen Tragering (18) umschlossen, um dem Linsenraster (20) eine ausreichende mechanische Festigkeit zu verleihen. Dieser Tragering (18), die Stege (16 aus Fig. 3) sowie die Haltekörper (17) an den Knotenpunkten der Stege sind aus einem Material, welches einen Ausdehnungskoeffizienten möglichst nahe des Ausdehnungskoeffizienten der Linsenelemente (15) hat, z.B. Invar. Am äußeren Tragering (18) des Linsenrasters (20) befindet sich an einer verdickten Stelle des Tragerings (18) eine Kerbe (19), um sicherzustellen, daß das Linsenraster (20) in seine Halterung richtig eingebaut wird und um dem Linsenraster (20) beim Einbau in die Halterung eine gewisse Vorausrichtung zu geben.

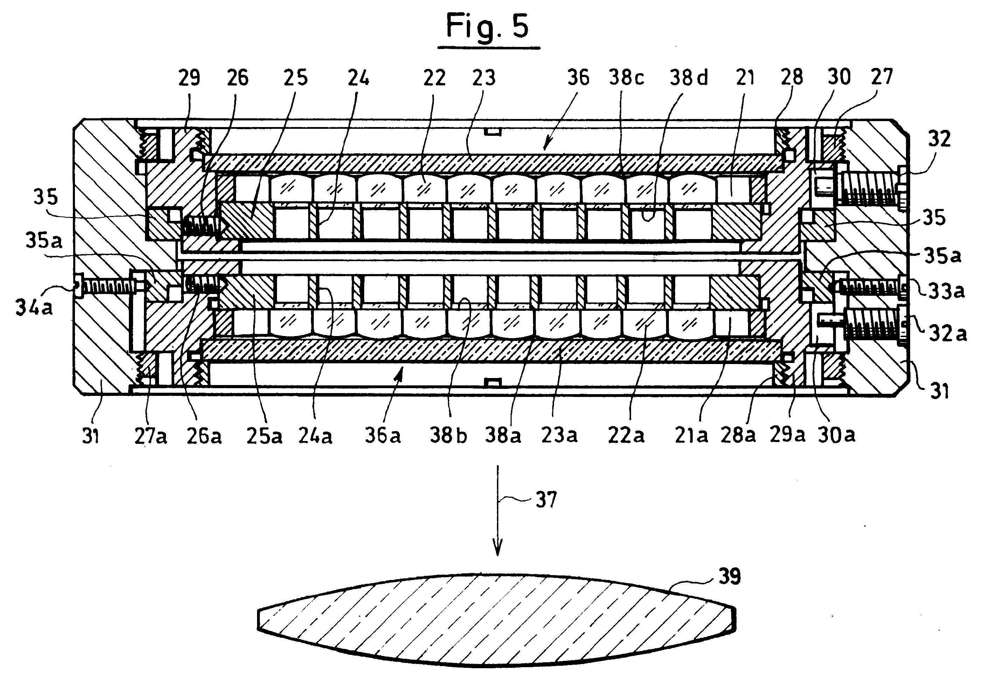

In Fig. 5 sind zwei, in eine Halterung (31) eingebaute Linsenraster (36,36a) gezeigt. Die Linsenelemente (22,22a) der beiden Linsenraster (36,36a) sind zueinander so ausgerichtet, daß jedes Linsenelement (22) des einen Linsenrasters (36) die durchgehenden parallelen Strahlen der Strahlenquelle genau auf ein zugeordnetes Linsenelement (22a) des anderen Linsenrasters (36a) abbildet, ohne daß es zu Abschattungen kommt. Um diese Ausrichtung der beiden Linsenraster (36,36a) zueinander exakt durchführen zu können, ist die Halterung (31) der Linsenraster (36,36a) mit Elementen versehen, welche die beiden Linsenraster (36,36a) relativ zueinander bewegen und fixieren können.

Die Linsenelemente (22,22a) haben eine leicht konische Form im oberen Bereich und einen Absatz im unteren Bereich. Mit dem verjüngten Teil der Linsenelemente (22,22a) nach dem Absatz ragen die Linsenelemente (22,22a) in die Freiräume des Linsenrasters (36,36a) hinein. Diese Freiräume werden von Stegen (24,24a) begrenzt, die sich innerhalb des äußeren, sie stabilisierenden Tragerings (25,25a) befinden. Mit ihren Absätzen liegen die Linsenelemente (22,22a) auf diesen Stegen (24,24a) fest auf, so daß die Linsenelemente (22,22a) sowohl von unten als auch nach beiden Seiten einen sicheren Halt haben. Der seitliche Halt der Linsenelemente (22,22a) wird durch einen äußeren Füllkörper (21,21a) zwischen den äußeren Linsenelementen (22,22a) und dem inneren, beweglichen Träger (29,29a) der Halterung (31) unterstützt.

Distanzringe (35,35a) zwischen Halterung (31) und Trägern (29,29a) sorgen dafür, daß der richtige Abstand zwischen den Linsenrastern (36,36a) besteht.

Im Träger (29,29a) wird das jeweilige Linsenraster (36,36a) mit kopflosen Fixierschrauben (26,26a) festgelegt. Eine Glasplatte (23,23a) oberhalb des Linsenrasters (36,36a) sorgt dafür, daß die Linsenelemente (22,22a) nicht aus dem Linsenraster (36,36a) fallen können, da die Linsenelemente (22,22a) nicht in Stege des Linsenrasters (36,36a) eingekittet sind. Werden die Linsenelemente (22,22a) an die Stege des Linsenrasters (36,36a) angekittet, kann man auf die Glasplatte (23,23a) verzichten. Führen allerdings Umweltbedingungen (Strahlung, chem. Substanzen, usw.) zu einer Zerstörung einer Kittschicht, so kann man mittels der Glasplatte (23,23a) für einen sicheren Halt der Linsenelemente (22,22a) in dem Linsenraster (36,36a) sorgen. Mit einem Spannring (28,28a) wird die Glasplatte (23,23a) auf dem Linsenraster (36,36a) in dem Träger (29,29a) festgelegt.

Die Distanzringe (35,35a) werden mittels Spannschrauben (33a,34a und 35a) in der Halterung fixiert. Außerdem kann man mit diesen Spannschrauben (33a,34a) das Linsenraster (36a) in der Ebene senkrecht zur optischen Achse (37) seitlich in einem gewissen, die Fertigungstoleranzen ausgleichenden Bereich verschieben.

Mit den Verstellschrauben (32,32a) kann man die beiden Linsenraster (36,36a) senkrecht zur optischen Achse (37) drehen. Dazu haben die Verstellschrauben (32,32a) einen außeraxialen Fortsatz an ihrem Ende. Dieser außeraxiale Fortsatz befindet sich in einer Öffnung (30,30a) des Trägers (29,29a) und sorgt dafür, daß die Linsenraster (36,36a) in einem engen Winkelbereich eine Links- oder Rechtsdrehung machen können. Sind die beiden Linsenraster, (36,36a) relativ zueinander exakt ausgerichtet, so kann man diese Ausrichtung durch einen Spannring (27,27a) für jeden Träger (29,29a) fixieren. Eine derartige Halterung (31) mit zwei Linsenrastern (36,36a) eignet sich zum Einsatz in einem Kondensor der Beleuchtungsoptik eines Wafersteppers, wobei eine hinter den beiden Linsenrastern (30,30a) angebrachte große Linse (39) dafür sorgt, daß sich die durch die Linsenraster (36,36a) erzeugten Strahlenbündel in einer Ebene zur Beleuchtung einer Vorlage überlagern.

Anstatt die Glasplatte (23,23a) direkt auf die Linsenelemente (22,22a) aufzulegen, kann man auf die Glasplatten (23,23a) auch kleine Distanzelemente aufbringen, welche die einzelnen Linsenelemente (22,22a) an ihren Eckpunkten im Linsenraster (36,36a) fixieren.

## Patentansprüche

1. Linsenraster aus diskreten Linsenelementen, bei welchem die zwei optisch wirksamen Flächen der Linsenelemente ungleich groß sind und die eine optisch wirksame Fläche der Linsenelemente konvex ist und bei welchem die Linsenelemente in einem Träger in Ausnehmungen angeordnet sind, welche durch Stege begrenzt sind, wobei die Stege des Trägers die einzelnen Linsenelemente an den Rändern der kleineren optischen Fläche unterstützen, dadurch gekennzeichnet,
daß die andere optisch wirksame Fläche (12ab, 12bb) der Linsenelemente (1, 15,, 15a-b, 22, 22a) konkav ist, daß die Linsenelemente (1, 15, 15a-b, 22, 22a) im optisch nicht genutzten Bereich des Linsenmaterials an mindestens zwei gegenüberliegenden Seiten unter Bildung jeweils eines als Auflagefläche dienenden Absatzes verjüngt sind, und daß die Stege (4a-e, 16, 24, 24a) des Trägers (18, 29, 29a) eine Breite entsprechend dem durch Verjüngungen maximal möglichen Freiraum zwischen zwei Linsenelementen (1, 15, 15a-b, 22, 22a) nicht überschreiten, wobei der Träger (18, 29, 29a) mit seinen Stegen (4a-e, 16, 24, 24a) die optisch wirksame Fläche der diskreten Linsenelemente (1, 15, 15a-b, 22, 22a) nicht einschränkt.

2. Linsenraster nach Anspruch 1, dadurch gekennzeichnet, daß die Flächendiagonale der optisch wirksamen Flächen der Linsenelemente (1,15,15a-b,22,22a) größer ist als die Linsendicke.

3. Linsenraster nach einem der Ansprüche 1-2, dadurch gekennzeichnet, daß die Linsenelemente (1,15,15a-b,22,22a) in einer Ebene so angeordnet sind, daß ihre größeren optisch wirksamen Flächen aneinandergrenzen.

4. Linsenraster nach einem der Ansprüche 1-3, dadurch gekennzeichnet, daß die Linsenelemente (1,15,15a-b,22,22a) im optisch nicht genutzten Bereich konisch verjüngt sind.

5. Linsenraster nach einem der Ansprüche 1-4, dadurch gekennzeichnet, daß die Linsenelemente (1,15,15a-b,22,22a) im optisch nicht genutzten Bereich zylinderförmig verjüngt sind.

6. Linsenraster nach einem der Ansprüche 1-5, dadurch gekennzeichnet, daß eine relativ zum Träger (29,29a) festgelegte, durchsichtige Planplatte (23,23a) vor den Linsenelementen (22,22a) angebracht ist.

7. Linsenraster nach einem der Ansprüche 1-6, dadurch gekennzeichnet, daß die Linsenelemente (1,15,15a-b,22,22a) an die Stege (4a-e,16,24,24a) des Trägers (18,29,29a) angeklebt sind.

8. System aus zwei gleich aufgebauten Linsenrastern (36,36a) nach einem der Ansprüche 1-7, dadurch gekennzeichnet, daß sie hintereinander angeordnet sind, so daß sie zueinander einen festen Abstand besitzen, die Linsenelemente (22,22a) in den beiden Linsenrastern (36,36a) einander die kleineren optisch genutzten Linsenoberflächen(38b,38d) zukehren und die Linsenelemente (22,22a) relativ zueinander fest ausgerichtet sind.

9. Linsenraster system nach Anspruch 8, dadurch gekennzeichnet, daß die Linsenraster (36,36a) in ihrem Träger (29,29a) als Teil des Kondensors der Beleuchtungsoptik in einen Waferstepper eingebaut sind.

## Claims

1. Lenticular array composed of discrete lens elements whose two optically effective surfaces of the lens elements are of different size and where the one optically effective surface of the lens elements is convex, the lens elements being arranged in openings of a carrier which are limited by struts, characterized in that the other optically effective surface (12ab, 12bb) of the lens elements (1, 15, 15a-b, 22, 22a) is concave, that the lens elements (1, 15, 15a-b, 22, 22a) are tapered at at least two opposing sides in the region of the lens material, which is not used optically, thus defining a step serving as support, and that the width of the struts (4a-e, 16, 24, 24a) of the carrier (18, 29, 29a) does not exceed a width according to the maximum free space between two lens elements (1, 15, 15a-b, 22, 22a) as possible by tapers, so that the carrier (18, 29, 29a) with its struts (4a-e, 16, 24, 24a) does not limit the optically effective area of the discrete lens elements (1, 15, 15a-b, 22, 22a).

2. Lenticular array according to claim 1, characterized in that the plane diagonal of the optically effective areas of the lens elements (1, 15, 15a-b, 22, 22a) is greater than the thickness of the lens elements.

3. Lenticular array according to one of claims 1 to 2, characterized in that the lens elements (1, 15, 15a-b, 22, 22a) are arranged in a plane in such a way, that their wider optically effective surfaces are mutually in touch.

4. Lenticular array according to one of the claims 1 to 3, characterized in that the lens elements (1, 15, 15a-b, 22, 22a) are tapered conically in the regions not used optically.

5. Lenticular array according to one of the claims 1 to 4, characterized in that the lens elements (1, 15, 15a-b, 22, 22a) are tapered cylindrically in the regions not used optically.

6. Lenticular array according to one of the claims 1 to 5, characterized in that a transparent plane plate (23, 23a), which is fastened to the carrier (29, 29a), is arranged in front of the lens elements (22, 22a).

7. Lenticular array according to one of the claims 1 to 6, characterized in that the lens elements (1, 15, 15a-b, 22, 22a) are cemented to the struts (4a-e, 16, 24, 24a) of the carrier (18, 29, 29a).

8. System comprising two lenticular arrays of the same construction according to one of the claims 1 to 7, characterized in that they are arranged successively so that their distance is fixed, the lens elements (22, 22a) in the two lenticular arrays (36, 36a) face each others smaller optically effective lens surfaces (38b, 38d) and the lens elements (22, 22a) are fixed in their relative positions.

9. Lenticular array system according to claim 8, characterized in that the lenticular arrays (36, 36a) in their carrier (29, 29a) are integrated into a wafer stepper as part of the condenser of the illuminating optics.

## Revendications

1. Réseau de lentilles constitué par des éléments de lentille discrets, dans lequel les deux surfaces, actives du point de vue optique, des éléments de lentille sont différentes et une surface, active du point de vue optique, des éléments de lentille est convexe, et dans lequel les éléments de lentille sont disposés dans un support, à l'intérieur d'évidements, qui sont limités par des barrettes, les barrettes du support supportant les différents éléments de lentille au niveau des bords de la surface optique la plus petite, caractérisé en ce
que l'autre surface active du point de vue optique (12ab, 12bb) des éléments de lentille (1,15,15a-b,22,22a) est concave, que les éléments de lentille (1,15,15a-b,22,22a) sont rétrécis, sur au moins deux côtés opposés, dans la partie du matériau des lentilles, qui n'est pas utilisée du point de vue optique, moyennant la formation respectivement d'un épaulement utilisé comme surface d'appui, et que les barrettes (4a-e,16,24,24a) du support (18,29,29a) ont une largeur qui ne dépasse pas la largeur correspondant à l'espace libre maximum possible en raison de la présence de rétrécissements, entre deux éléments de lentille (1,15, 15a-b,22,22a), le support (18,29,29a) équipé de ses barrettes (4a-e,16,24,24a) ne limitant pas la surface, active du point de vue optique, des éléments de lentille discrets (1,15,15a-b,22,22a).

2. Réseau de lentilles selon la revendication 1, caractérisé en ce que la diagonale des surfaces, actives du point de vue optique des éléments de lentille (1,15,15a-b, 22,22a), est supérieure à l'épaisseur des lentilles.

3. Réseau de lentilles suivant l'une des revendications 1-2, caractérisé en ce que les éléments de lentille (1,15,15a-b,22,22a) sont disposés dans un plan de telle sorte que leurs surfaces actives du point de vue optique, qui sont les plus grandes, sont contiguës.

4. Réseau de lentilles selon l'une des revendications 1-3, caractérisé en ce que les éléments de lentille (1,15,15a-b,22,22a) se rétrécissent avec une forme optique dans la zone non utilisée du point de vue optique.

5. Réseau de lentilles selon l'une des revendications 1-4, caractérisé en ce que les éléments de lentille (1,15,15a-b,22,22a) sont rétrécis avec une forme cylindrique dans la zone non utilisée du point de vue optique.

6. Réseau de lentilles selon l'une des revendicatons 1-5, caractérisé en ce qu'une plaque plane transparente (23,23a), qui est fixée par rapport au support (29,29a), est montée en avant des éléments de lentille (1,15,15a-b,22,22a).

7. Réseau de lentilles selon l'une des revendications 1-6, caractérisé en ce que les éléments de lentille (1,15,15a-b,22,22a) sont collés sur les barrettes (4a-e, 16,24,24a) du support (18,29,29a).

8. Système constitué par deux réseaux de lentilles (36,36a), agencés de la même manière, selon l'une des revendications 1-7, caractérisé en ce qu'ils sont disposés l'un derrière l'autre, qu'ils sont séparés par une distance fixe, que les surfaces utilisées optiquement (38b,38c), qui sont les plus petites, les éléments de lentille (22,22a) dans les deux réseaux de lentilles (36,36a) se font face et que les éléments de lentille (22,22a) sont orientés de façon fixe les uns par rapport aux autres.

9. Système de réseaux de lentilles selon la revendication 8, caractérisé en ce que les réseaux de lentilles (36,36a) sont montés dans leur support (29,29a), en tant que partie du condenseur du système optique d'éclairement d'un système de formation de parties étagées dans des pastilles.
